# EUROPÄISCHE PATENTSCHRIFT

(11) **EP 2 543 004 B1**
(45) Veröffentlichungstag und Bekanntmachung des Hinweises auf die Patenterteilung: **02.09.2015**
(21) Anmeldenummer: 11706228.1
(22) Anmeldetag: 25.02.2011
(51) Int. Cl.: G06K 19/077

(54) **DOKUMENT MIT EINEM BUCHDECKEL**
DOCUMENT WITH BOOK COVER
DOCUMENT DE LIVRE A COUVERTURE RIGIDE

(30) Priorität: 01.03.2010 DE 102010002464
(43) Veröffentlichungstag der Anmeldung: 09.01.2013
(73) Patentinhaber: Bundesdruckerei GmbH, 10958 Berlin (DE)
(72) Erfinder: FISCHER, Joerg, 13053 Berlin (DE); PAESCHKE, Manfred, 16348 Wandlitz (DE); TIETKE, Markus, 10365 Berlin (DE); FRITZE, Frank, 12487 Berlin (DE)
(74) Vertreter: Richardt Patentanwälte PartG mbB
(86) Internationale Anmeldenummer: PCT/EP2011/052815
(87) Internationale Veröffentlichungsnummer: WO 2011/107402

(56) Entgegenhaltungen:
- DE-A1-102005 030 626
- DE-A1-102005 030 628
- DE-A1-102006 009 128
- US-B2- 7 360 712

## Beschreibung

Die Erfindung betrifft ein Dokument mit einem Buchdeckel, insbesondere ein Ausweisdokument, wie zum Beispiel ein sogenanntes Passbuch.

Aus der DE 10 2004 008 841 A1 ist ein Passbuch mit einem in einer Buchdeckeleinlage angeordneten RFID-Datenträger bekannt.

Aus der WO 2006/053679 ist ein Passbuch mit einem Einlageblatt bekannt, welches eine Schicht aus thermoplastischem Elastomer aufweist, die eine Transpondereinheit trägt.

Aus DE 10 2005 030 626 A1 ist ein Dokument in der Art eines Reisepasses bekannt mit einer Personalisierseite, die ein Anzeigefeld und einen integrierte Schaltung trägt. Die integrierte Schaltung und das Anzeigefeld sind mit einer flexiblen Verdrahtung verbunden, wobei sich die flexible Verdrahtung ebenfalls auf der Personalisierseite befindet.

Die Erfindung stellt sich die Aufgabe, das vorangehend erwähnte Dokument fertigungsgerecht zu verbessern und ein Verfahren zur Herstellung eines solchen verbesserten Dokuments zu schaffen.

Die der Erfindung zugrunde liegenden Aufgaben werden jeweils mit den Merkmalen der unabhängigen Patentansprüche gelöst. Ausführungsformen der Erfindung sind in den abhängigen Patentansprüchen angegeben.

Nach Ausführungsformen der Erfindung wird ein Dokument mit einem Buchdeckel und einer Personalisierseite geschaffen. Der Buchdeckel und die Personalisierseite sind durch eine Buchbindung verbunden. Die Personalisierseite trägt eine Anzeigevorrichtung zur Anzeige von einem oder mehreren Bildern, beispielsweise zur Anzeige von ein oder mehreren Passbildern, insbesondere zur sequenziellen Anzeige von Portraitaufnahmen und/oder textueller Information und/oder 2D-Barcodes.

Das Dokument hat eine elektronische Schaltung zur Ansteuerung der Anzeigevorrichtung, wobei die elektronische Schaltung in dem Buchdeckel integriert ist. Eine flexible Leiterplatte erstreckt sich.zwischen der Anzeigevorrichtung und der Schaltung, sodass die Schaltung die Anzeigevorrichtung über auf der Leiterplatte angeordnete elektrische und/oder elektronische Komponenten, insbesondere Leiterbahnen, ansteuern kann.

Ausführungsformen der Erfindung sind besonders vorteilhaft, da zumindest ein Teil der für den Betrieb der Anzeigevorrichtung erforderlichen Elektronik in dem Buchdeckel in Form der elektronischen Schaltung untergebracht ist, sodass die Personalisierseite entsprechend dünner und flexibler ausgebildet werden kann. Ferner kann die Sicherheit gegen Nachstellungen oder Fälschungen hierdurch verbessert werden. Insbesondere wird ein Heraustrennen der Personalisierungsseite aus dem buchförmigen Dokument und das Einbringen der Personalisierungsseite in ein anderes gleich aufgebautes Dokument hierdurch erschwert.

Nach Ausführungsformen der Erfindung handelt es sich bei dem Dokument um ein Wert- oder Sicherheitsdokument, wie zum Beispiel ein Ausweisdokument, insbesondere einen Reisepass, Personalausweis, Visum oder einen Führerschein, Fahrzeugschein, Fahrzeugbrief, Firmenausweis, Gesundheitskarte oder ein anderes ID-Dokument, ein Zahlungsmittel, einen Frachtbrief oder einen sonstigen Berechtigungsnachweis, der buchförmig ausgebildet ist.

Unter "Personalisierseite" wird hier eine Seite des Dokuments verstanden, die zur Personalisierung vorgesehen oder bereits personalisiert ist. Beispielsweise beinhaltet die Personalisierseite eine oder mehrere Kunststoffschichten zur Laserpersonalisierung. Die Personalisierseite kann textuelle Angaben zu dem Inhaber des Dokuments aufweisen sowie eine maschinenlesbare Zeile, insbesondere eine von der internationalen Luftfahrtbehörde (ICAO) spezifizierte Machine Readable Zone (MRZ).

Unter einer "Buchbindung" wird hier jede Form der Verbindung einer Seite eines buchförmigen Dokuments, insbesondere der Personalisierungseite, mit dem Buchdeckel verstanden, insbesondere mit Hilfe eines Fadens und/oder einer Klebebindung, insbesondere durch dem Fachmann bekannte Buchbindungstechniken, wie zum Beispiel Kaschieren, Einkleben, Einnähen usw.

Ergänzend zu der erfindungsgemäßen Anzeigevorrichtung kann die Personalisierseite ein Passfoto des Inhabers tragen, welches aufgedruckt oder mittels Laserpersonalisierung in die Personalisierseite eingebracht sein kann; bei dem Passfoto kann es sich um ein Schattenbild handeln.

Unter einer "flexiblen Leiterplatte" wird hier insbesondere eine biegsame Schicht verstanden, auf die ein oder mehrere elektrische oder elektronische Komponenten aufgebracht sind, insbesondere ein oder mehrere Leiterbahnen. Solche flexiblen Leiterplatten werden auch als Printed Circuit Board (PCB) bezeichnet und werden im Stand der Technik zum Beispiel für elektronische Kameras eingesetzt.

Nach einer Ausführungsform der Erfindung hat die Personalisierseite eine Dicke zwischen 150 µm und 600 µm, insbesondere zwischen 150 µm und 400 µm. Eine solch flache Bauform wird trotz der Integration der Anzeigevorrichtung in die Personalisierseite dadurch ermöglicht, dass zumindest ein Teil der für die Ansteuerung der Anzeigenseite und deren Energieversorgung erforderlichen Komponenten nicht in die Personalisierseite, sondern den Buchdeckel integriert sind.

Nach einer Ausführungsform der Erfindung hat die Personalisierseite zumindest zwei einander gegenüberliegende Kunststoffschichten, zwischen denen die Anzeigevorrichtung und ein erster Bereich der flexiblen Leiterplatte, welcher die Anzeigevorrichtung kontaktiert, angeordnet sind. Ein zweiter Bereich der Leiterplatte ragt aus der Personalisierseite hervor. Dieser zweite Bereich trägt die elektronische Schaltung, die bei der Verbindung der Personalisierseite mit dem Buchdeckel in einer Ausnehmung des Buchdeckels untergebracht wird.

Nach einer Ausführungsform der Erfindung handelt es sich bei der in das Dokument integrierten Anzeigevorrichtung um eine bistabile Anzeigevorrichtung, eine elektrophoretische Anzeige, eine elektrochrome Anzeige, eine Flüssigkeitskristallanzeige (LCD), LED-Anzeige, insbesondere anorganische LED- oder organische LED-Anzeige (OLED), Drehelementanzeige, Balkenanzeige, Photolumineszenz-Löschungsanzeige oder eine Anzeige auf Basis des Elektrowetting-Effekts oder eine Hybridanzeige.

Nach einer Ausführungsform der Erfindung beinhaltet die elektronische Schaltung einen Speicher zur Speicherung von Bilddaten, d.h. von Daten, die zur bildlichen Wiedergabe vorgesehen sind, und eine Logikkomponente, insbesondere einen Mikroprozessor, zur Ansteuerung der Anzeigevorrichtung für die Wiedergabe der Bilddaten.

Die Logikkomponente kann eine Treiberschaltung für die Anzeigevorrichtung beinhalten. Je nach Ausführungsform kann die Treiberschaltung aber auch zum Beispiel als Teil der Anzeigevorrichtung in die Personalisierseite integriert sein. Die Logikschaltung kann ein oder mehrere kryptografische Protokolle implementieren, insbesondere für eine sogenannte Basis Access Control (BAC) und/oder eine Extended Access Control (EAC), wie von der Internationalen Luftfahrtbehörde (ICAO) spezifiziert.

Nach einer Ausführungsform der Erfindung ist eine Antenne oder eine Spule in den Buchdeckel integriert, um elektrische Energie zum Betrieb der elektronischen Schaltung und/oder der Anzeigevorrichtung in das Dokument einzukoppeln. Beispielsweise ist die elektronische Schaltung als RFID-Chip ausgebildet, wobei über die Spule nach einem RFID-Verfahren oder einem NFC-Verfahren induktiv elektrische Energie eingekoppelt wird.

Nach einer Ausführungsform der Erfindung ist die Spule mit der flexiblen Leiterplatte elektrisch verbunden, wie zum Beispiel in dem Bereich der Leiterplatte, die aus der Personalisierseite herausragt. Hierdurch ist eine besonders kosteneffizient herstellbare Kontaktierung der Spule mit der elektronischen Schaltung und/oder der Anzeigevorrichtung gegeben.

Nach einer Ausführungsform der Erfindung wird die Anzeigevorrichtung durch einen anisotrop leitfähigen Film (Anisotrop Conductive Film - ACF) elektrisch kontaktiert.

Nach einer Ausführungsform der Erfindung wird die Personalisierseite mit ein oder mehreren Innenbögen des Dokuments durch eine Naht verbunden, wobei die Naht einen Faden aufweist, der durch die Leiterplatte verläuft. Die Innenbögen können zum Beispiel aus Papier bestehen und für spätere Eintragungen, wie zum Beispiel Visa, vorgesehen sein.

Nach einer Ausführungsform der Erfindung ist der Faden der Naht zumindest in einem Abschnitt leitfähig und stellt einen elektrischen Kontakt zwischen zumindest ersten und zweiten Leiterbahnen der Leiterplatte her. Hierdurch ist eine besonders innige Verbindung zwischen der Leiterbahn und dem Dokument gegeben, was die Fälschungssicherheit weiter erhöht.

Nach einer Ausführungsform der Erfindung trägt die Leiterplatte eine erste Leiterbahn, die mit der elektronischen Schaltung verbunden ist, und eine zweite Leiterbahn, die mit der Anzeigevorrichtung verbunden ist. Die erste Leiterbahn und die zweite Leiterbahn werden durch den Faden der Naht elektrisch miteinander verbunden. Die elektronische Schaltung beinhaltet eine Abfragelogik, um zu prüfen, ob dies tatsächlich der Fall ist. Wenn diese elektrische Verbindung nicht besteht, so deutet dies auf eine Fälschung des Dokuments hin, sodass die elektronische Schaltung die Anzeigevorrichtung nicht ansteuert, also kein Bild auf der Anzeigevorrichtung erscheint, auch dann nicht, wenn Energie in das Dokument eingekoppelt wird.

Nach einer Ausführungsform der Erfindung erfolgt die Spannungsversorgung der elektronischen Schaltung und/oder der Anzeigevorrichtung über einen Abschnitt des Fadens der Naht, wodurch ein weiteres Sicherheitsmerkmal gegeben ist. Alternativ oder zusätzlich wird durch den Faden eine Brücke über ein oder mehrere Leiterbahnen gebildet, die auf der Leiterplatte angeordnet sind. Bei den Leiterbahnen kann es sich zum Beispiel um Zeilen- oder Spaltenleitungen handeln, um die Anzeigevorrichtung, die dann als Matrixdisplay ausgebildet ist, anzusteuern.

Nach einer Ausführungsform der Erfindung sind die elektronische Schaltung und ein Bereich der Leiterplatte unter einem Vorsatz des Buchdeckels angeordnet.

Nach einer Ausführungsform der Erfindung ist die elektronische Schaltung als RFID-Elektronik gemäß ISO 14443 A/B oder ICAO 9303MRTD ausgebildet und in den vorderen und/oder hinteren Passbuchdeckel integriert.

Gemäß einer Ausführungsform der Erfindung handelt es sich bei der Anzeigevorrichtung um eine Active Matrix OLED-Anzeigevorrichtung. Die Anzeigevorrichtung kann ein dünnes flexibles Glassubstrat von etwa 50 µm Dicke mit einer anorganischen Passivierungsschicht bzw. Barriereschicht aufweisen. Die flexible Leiterplatte kann beispielsweise aus Polyamid (PI) und die Personalisierseite kann ein oder mehrere Polycarbonat (PC)-Schichten aufweisen, in die die Leiterplatte laminiert sein kann. Die flexible Leiterplatte kann über den Passrücken auf die vordere oder hintere Innenseite des Passbuchdeckels geführt sein.

Die Personalisierseite kann ein oder mehrere Schichten aus einem thermoplastischen Polyurethan (TPU) aufweisen. Es können jedoch auch weitere thermoplastische Elastomere eingesetzt werden. Hierfür stehen die gesamte Gruppe der thermoplastischen Polyurethane, die Gruppe der thermoplastischen Copolyesther und die Gruppe der thermoplastischen Polyether-Block-Amide zur Verfügung. Als hochtemperaturstabile Kunststoffe können beispielsweise Polycarbonat (PC), Polyethersulfon (PES), Polyetherketon (PEEK), Polyphenylenoxid (PPO), Polyphenylensulfid (PPS), Polyethylentherephtalat (PET), insbesondere PETg oder PETf, Polybutylentherephtalat (PBT), Polyoxymethylen (POM), Polysulfon (PSU), Polyetherimid (PEI) oder Polyamid (PA) angewendet werden. Nach einer weiteren Ausführungsform können eine oder mehrere der Schichten Acrylnitril-Butadien-Styrol-Copolymerisat (ABS) und/oder Polyethylennaphthalat (PEN) aufweisen.

Nach einer Ausführungsform der Erfindung wird die OLED-Anzeigevorrichtung einoder beidseitig mit einer dünnen Polycarbonatschicht versehen. Dies kann durch Tauchen, Sprühen, Rakeln, Rollenbeschichtung, Siebdruck oder dergleichen Methoden aus der Lösung erfolgen, oder kann durch Laminationstechnik mittels dünner Polycarbonatfolien durchgeführt werden. Hierdurch wird neben der OLED-Anzeigevorrichtung auch ein Abschnitt der flexiblen Leiterplatte abgedeckt. Eine derart geschützte OLED-Anzeigevorrichtung ist wesentlich unempfindlicher bei Biegungen und kann daher leicht mit anderen Polycarbonatfolien zu einer Personalisierseite laminiert werden.

Nach einer Ausführungsform der Erfindung ist die Anzeigevorrichtung konform zu dem Standard ICO 9303 ausgebildet.

In einem weiteren Aspekt betrifft die Erfindung ein Verfahren zur Herstellung eines Dokuments. Das Verfahren beinhaltet die folgenden Schritte: Herstellung einer Personalisierseite mit einer Anzeigevorrichtung und einer flexiblen Leiterplatte, welche die Anzeigevorrichtung kontaktiert, wobei die Leiterplatte einen Bereich aufweist, der aus der Personalisierseite herausragt, wobei der aus der Personalisierseite herausragende Bereich eine elektronische Schaltung zur Ansteuerung der Anzeigevorrichtung aufweist, Befestigung des Bereichs in einem Buchdeckel sowie schwenkbare Befestigung der Personalisierseite an dem Buchdeckel.

Zur Herstellung der Personalisierseite kann beispielsweise so vorgegangen werden, dass die Anzeigevorrichtung mit der flexiblen Leiterplatte kontaktiert wird, beispielsweise mit Hilfe eines anisotrop leitenden Films (Anisotrop Conductive Film -ACF). Die Anzeigevorrichtung und ein Abschnitt der flexiblen Leiterbahn werden dann mit einer Kunststoffschicht versehen, wie zum Beispiel mit einer Polycarbonatschicht. Die derart geschützte Anzeigevorrichtung mit der kontaktierten flexiblen Leiterbahn kann dann mit weiteren Kunststoff- oder Papierschichten zu der Personalisierseite gefügt werden, beispielsweise indem die Anzeigevorrichtung mit der kontaktierten flexiblen Leiterplatte mit weiteren Polycarbonatfolien zu der Personalisierseite laminiert wird.

Nach einer Ausführungsform der Erfindung wird die Personalisierseite durch eine Naht mit weiteren Innenbögen verbunden. Vorzugsweise verläuft die Naht durch einen aus der Personalisierseite herausragenden Bereich der flexiblen Leiterplatte. Hierbei kann vorgesehen sein, dass der Faden der Naht ein oder mehrere elektrische Kontakte auf der Leiterbahn schließt.

Im Weiteren werden Ausführungsformen der Erfindung mit Bezugnahme auf die Zeichnungen näher erläutert. Es zeigen:
- Figur 1: eine perspektivische schematische Darstellung einer Ausführungsform eines erfindungsgemäßen buchförmigen Dokuments,
- Figur 2: ein Blockdiagramm einer Ausführungsform eines erfindungsgemäßen Dokuments,
- Figur 3: ein Blockdiagramm einer weiteren Ausführungsform eines erfindungsgemäßen Dokuments, wobei der Treiber in dem Buchdeckel angeordnet ist,
- Figur 4: ein Blockdiagramm einer weiteren Ausführungsform eines erfindungsgemäßen Dokuments, wobei der Treiber in der Personalisierseite angeordnet ist,
- Figur 5: eine Draufsicht einer Ausführungsform eines erfindungsgemäßen Dokuments, mit der Schaltung im vorderen Buchdeckel,
- Figur 6: eine Draufsicht einer weiteren Ausführungsform eines erfindungsgemäßen Dokuments mit der Schaltung in dem hinteren Buchdeckel,
- Figur 7: eine perspektivische Ansicht einer weiteren Ausführungsform eines erfindungsgemäßen Dokuments,
- Figur 8: eine Detailansicht eines Bereichs der flexiblen Leiterbahn, durch welchen die Naht verläuft.

Im Weiteren werden einander entsprechende Elemente der nachfolgenden Ausführungsformen mit denselben Bezugszeichen gekennzeichnet.

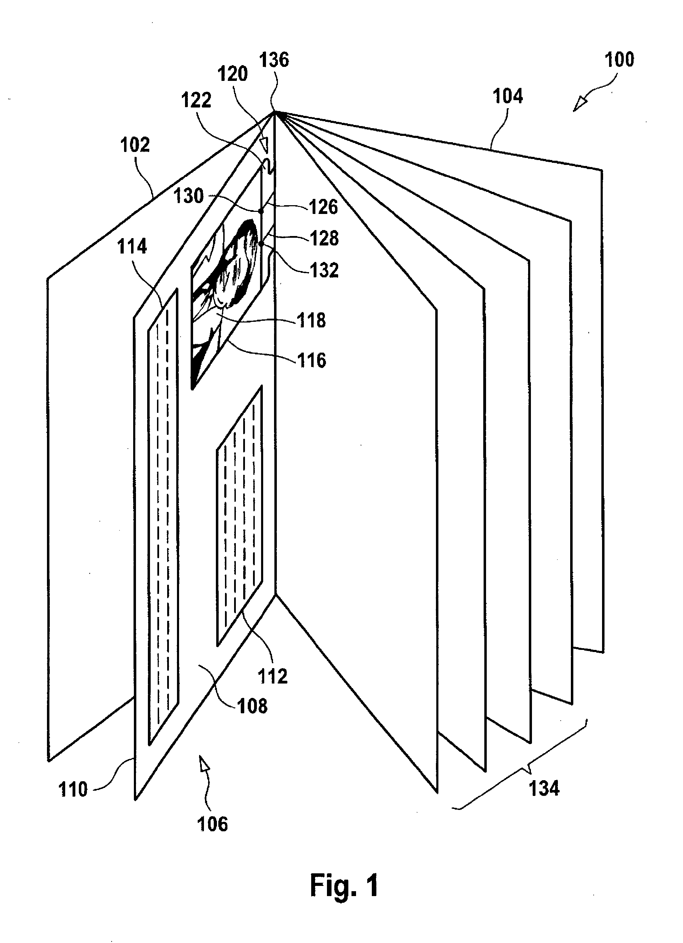

Die Figur 1 zeigt eine Ausführungsform eines erfindungsgemäßen Dokuments 100, welches buchförmig ausgestaltet ist. Bei dem Dokument 100 kann es sich insbesondere um ein Ausweisdokument, beispielsweise ein Passbuch, handeln. Bei dem Dokument 100 kann es sich um einen Dokumentenrohling oder ein bereits teilweise oder ganz personalisiertes Dokument handeln.

Das Dokument 100 hat einen vorderen Buchdeckel 102, insbesondere einen vorderen Passbuchdeckel, und einen hinteren Buchdeckel 104, insbesondere einen hinteren Passbuchdeckel.

Zwischen den Buchdeckeln 102 und 104 befindet sich eine Personalisierseite 106. Die Personalisierseite 106 kann einen schichtförmigen Aufbau aufweisen, wobei die Vorderseite der Personalisierseite 106 durch eine erste Schicht 108 und die Rückseite der Personalisierseite 106 durch eine zweite Schicht 110 gebildet wird. Bei den Schichten 108 und 110 kann es sich um Kunststoffschichten handeln, insbesondere um Polycarbonatschichten.

Zwischen den Schichten 108 und 110 können sich weitere Kunststoff- und/oder Papierschichten befinden, die zum Beispiel durch Laminierung miteinander zur Bildung der Personalisierseite 106 verbunden sind. Insbesondere kann der dadurch gegebene Schichtaufbau der Personalisierseite 106 für eine Laserpersonalisierung oder zur Durchführung anderer Personalisierverfahren ausgebildet sein. Durch die Personalisierung wird zum Beispiel auf die Vorderseite der Personalisierseite 106 ein Textfeld 112 eingebracht, welches persönliche Angaben zu dem Inhaber des Dokuments 100 beinhaltet, wie zum Beispiel dessen Namen, Geburtsdatum und Anschrift. Ein weiteres Textfeld 114 auf der Vorderseite der Personalisierseite 106 kann maschinenlesbar ausgebildet sein, insbesondere als sogenannte Machine Readable Zone (MRZ), wie von der ICAO spezifiziert.

Zwischen den Schichten 108 und 110 ist in der Personalisierseite 106 eine Anzeigevorrichtung 116 integriert. Bei der Anzeigevorrichtung 116 kann es sich beispielsweise um eine bistabile Anzeigevorrichtung handeln, die auch dann ein Bild 118, wie zum Beispiel ein Passfoto, zeigen kann, wenn keine elektrische Energieversorgung zur Verfügung steht, oder um ein emissives Display, wie zum Beispiel ein OLED-Display, insbesondere ein Active Matrix (AM) OLED-Display.

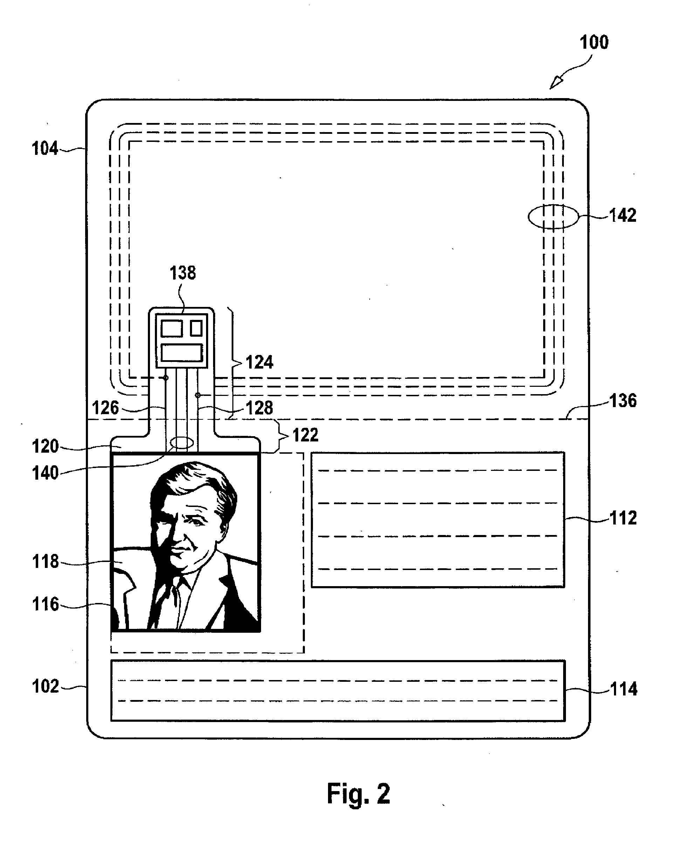

Die Anzeigevorrichtung 116 ist mit einer flexiblen Leiterplatte 120 elektrisch verbunden. Die Leiterplatte 120 hat einen Bereich 122, der in der Personalisierseite 106 beinhaltet ist, sowie einen Bereich 124 (vgl. Figur 2), der sich außerhalb der Personalisierseite 106 befindet.

Auf der Leiterplatte 120 können verschiedene elektrische und/oder elektronische Komponenten angeordnet sein, insbesondere ein Leiter 126 und ein Leiter 128. Die Enden der Leiter 126 und 128 sind hier mit entsprechenden Anschlusskontakten 130 und 132 der Anzeigevorrichtung 116 elektrisch verbunden, wie zum Beispiel mit Hilfe eines ACF. Insbesondere kann eine Kante der Anzeigevorrichtung 116 mit einem Endbereich der Leiterplatte 120 mittels ACF verbunden sein, wobei eine Passivierungsschicht, die auf der Leiterplatte 120 aufgebracht ist, an den Stellen unterbrochen ist, an denen sich die Anschlusskontakte 130 und 132 befinden, sodass mittels des ACF dort elektrische Kontakte ausgebildet werden.

Über die Leiter 126 und 128 kann beispielsweise die Spannungsversorgung der Anzeigevorrichtung 116 erfolgen oder deren Ansteuerung. Vorzugsweise sind die Anzeigevorrichtung 116 und der Bereich 122 der Leiterplatte 120 zwischen den Schichten 108 und 110 in der Personalisierseite 106 eingekapselt, sodass sie vor Umwelteinflüssen geschützt sind.

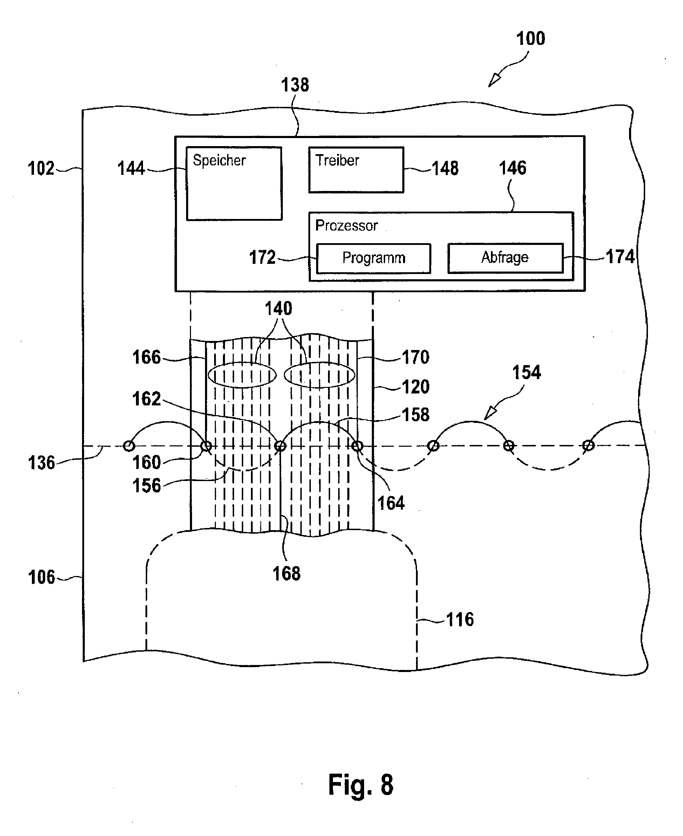

Das Dokument 100 hat ein oder mehrere Innenbögen 134, insbesondere Passbuch-Innenbögen, aus Papier oder einem papierähnlichen Material. Die Personalisierseite 106 und die Innenbögen 134 sind durch eine Naht 136 miteinander verbunden sowie auch mit den Buchdeckeln 102 und 104. Alternativ oder zusätzlich kann auch eine andere Art der Bindung gewählt werden, wie z.B. eine Klebebindung. Die Leiter 126, 128 und/oder die Leitungen 140 können über oder durch die Bindung hindurch verlaufen, vgl. z.B. die Ausführungsform der Fig. 8.

Die Figur 2 zeigt ein Blockdiagramm eines erfindungsgemäßen Dokuments 100. Bei dieser Ausführungsform trägt der Bereich 124 der Leiterplatte 120 eine elektronische Schaltung 138 zur Ansteuerung der Anzeigevorrichtung 116. Der Bereich 124 mit der elektronischen Schaltung 138 ist bei der hier betrachteten Ausführungsform in den Buchdeckel 104 integriert. Die elektronische Schaltung 138 dient zur Ansteuerung der Anzeigevorrichtung 116. Hierzu ist die elektronische Schaltung 138 über Leitungen 140 mit der Anzeigevorrichtung 116 verbunden.

Bei der hier betrachteten Ausführungsform ist die elektronische Schaltung 138 als ein RFID-Chip ausgebildet, der über die Leitungen 126 und 128 mit einer Spule 142 verbunden ist. Die Spule 142 ist ebenfalls in den Buchdeckel 104 integriert und dient zur Einkopplung von elektrischer Energie von einem Lesegerät sowie zur Kommunikation mit dem Lesegerät. Die Kommunikation kann nach einem RFID-Verfahren oder einem NFC-Verfahren erfolgen. Beispielsweise sendet das Lesegerät eine Trägerwelle ab, durch die induktiv elektrische Energie in die Spule 142 eingekoppelt wird, sodass für die elektronische Schaltung 138 und die Anzeigevorrichtung 116 eine Spannungsversorgung resultiert.

Die elektronische Schaltung 138 kann einen Speicher zur Speicherung von Bilddaten aufweisen, auf den die elektronische Schaltung 138 zugreift, um die Anzeigevorrichtung 116 zur Wiedergabe der Bilddaten anzusteuern, sobald elektrische Energie in die Spule 142 eingekoppelt wird. Die elektronische Schaltung 138 kann weitere funktionelle Komponenten beinhalten, wie zum Beispiel zur Speicherung schutzbedürftiger Daten, insbesondere von biometrischen Daten des Inhabers des Dokuments 100, sowie kryptografische Funktionen zur Implementierung zum Beispiel einer Basis Access Control (BAC) und/oder Extended Access Control (EAC), wie von der ICAO spezifiziert.

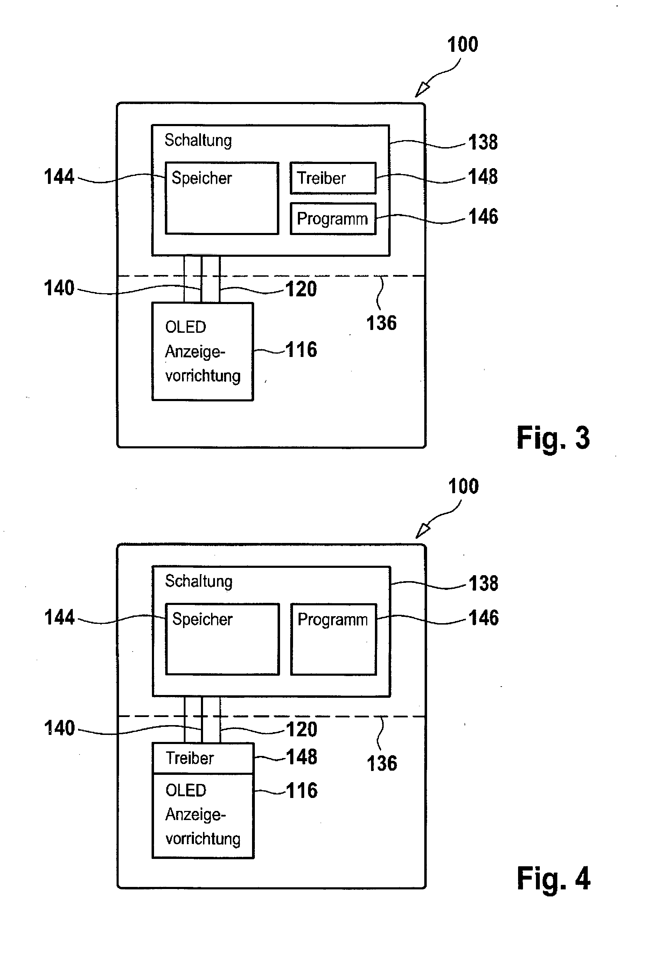

Die Figur 3 zeigt eine Ausführungsform der elektronischen Schaltung 138 des Dokuments 100. Die elektronische Schaltung 138 hat einen Speicher 144 zur Speicherung von Bilddaten. Beispielsweise ist in dem Speicher 144 eine digitale Portraitaufnahme des Inhabers des Dokuments 100 gespeichert, wie zum Beispiel im Format JPEG. Es können in dem Speicher 144 auch mehrere Bilder gespeichert sein, wie zum Beispiel eine Bildsequenz von aus unterschiedlichen Aufnahmewinkeln aufgenommenen Portraitbildern. In dem Speicher 144 können auch weitere Daten zur Erzeugung einer Anzeige auf der Anzeigevorrichtung 116 gespeichert sein, wie zum Beispiel textuelle Informationen, ein 2D-Barcode oder dergleichen. Die Schaltung 138 beinhaltet einen Mikroprozessor 146 zur Ausführung von Programminstruktionen sowie einen Treiber 148, über den die Anzeigeelemente der Anzeigevorrichtung 116 unmittelbar angesteuert werden, zum Beispiel über Spalten- und Zeilenleitungen.

Im Betrieb greift der Mikroprozessor 146 durch Ausführung der Programminstruktionen auf die in dem Speicher 144 gespeicherten Daten zu und steuert dann mit Hilfe der aus dem Speicher 144 gelesenen Daten den Treiber 148 zur Wiedergabe eines entsprechenden Bildes auf der Anzeigevorrichtung 116 an.

Wie in der Figur 4 gezeigt, kann der Treiber ein integraler Bestandteil der Anzeigevorrichtung 116 sein, also in der Personalisierseite 106 angeordnet sein. In diesem Fall steuert der Mikroprozessor 146 den Treiber über die Leitungen 140 an.

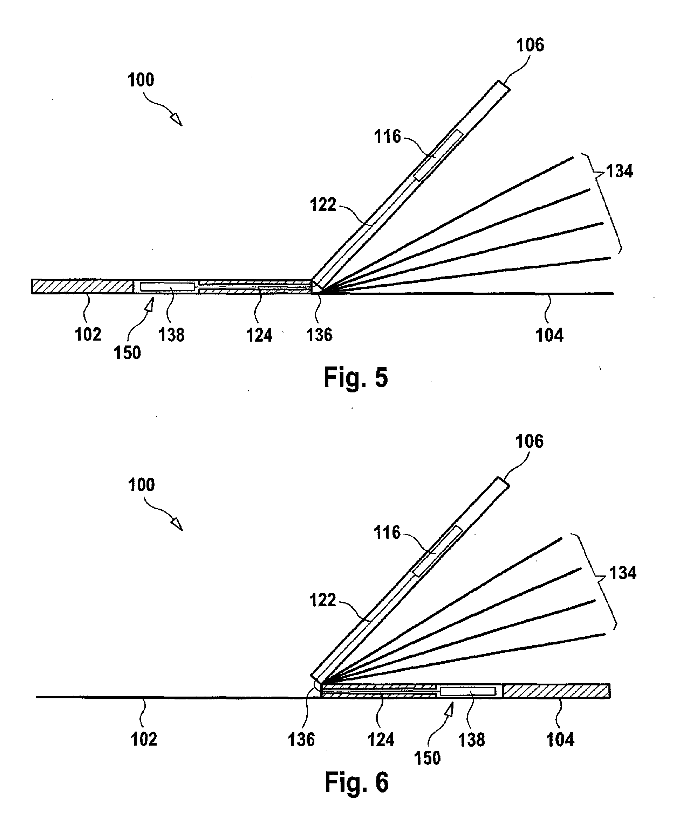

Die Figur 5 zeigt eine Ausführungsform des Dokuments 100, bei der die elektronische Schaltung 138 in einer Kavität 150 des Buchdeckels 102 angeordnet ist. Durch den Buchdeckel hindurch verläuft der Bereich 122 der Leiterplatte 120, wie in der Figur 5 dargestellt.

Die Figur 6 zeigt eine alternative Ausführungsform, bei der die Kavität 150 mit der elektronischen Schaltung 138 in dem hinteren Buchdeckel 104 angeordnet ist.

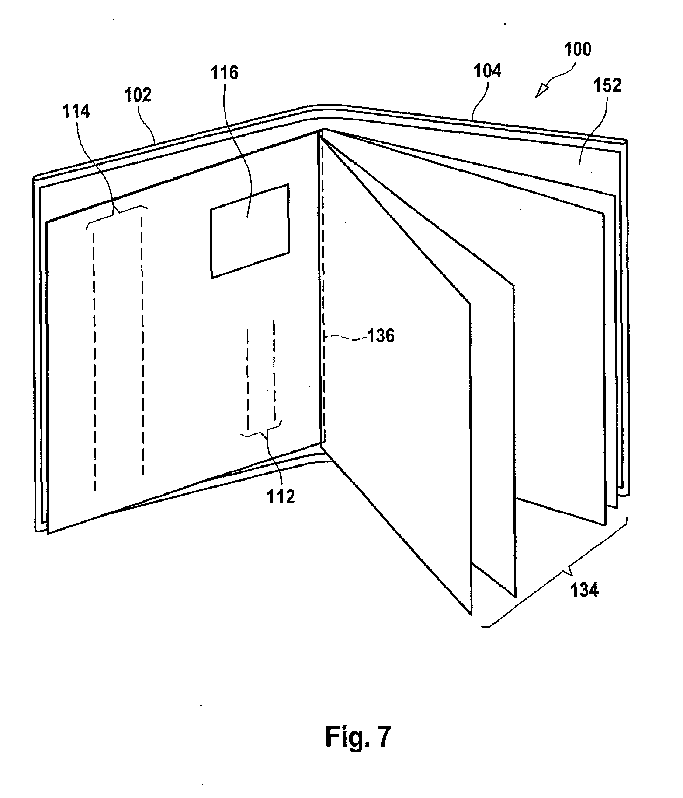

Die Figur 7 zeigt eine Ausführungsform des Dokuments 100, bei der mehrere Innenbögen 134 über die Naht 136 mit der Personalisierseite 106 verbunden sind. Die Personalisierseite 106 mit den Innenbögen 134 sind mit einem Vorsatz 152 der Buchdeckel 102 und 104 zum Beispiel durch eine Klebung verbunden. Der Vorsatz 152 schließt nach oben die Kavität 150 (vgl. Figuren 5 und 6) ab.

Die Figur 8 zeigt eine Detailansicht der flexiblen Leiterplatte 120 in dem Übergangsbereich zwischen dem Bereich 122, der sich in der Personalisierseite 106 befindet, und dem Bereich 124, der sich in dem Buchdeckel 102 bzw. dem Buchdeckel 104 befindet. Durch diesen Übergangsbereich hindurch verläuft die Naht 136, die einen Faden 154 aufweist. Der Faden besteht aus einem leitfähigen Material oder ist mit einem leitfähigen Material zumindest abschnittsweise beschichtet.

Bei der hier betrachteten Ausführungsform bildet der Faden 154 in dem Übergangsbereich der Leiterplatte 120 zwei Brücken 156 und 158, unter denen die Leitungen 140 hindurch verlaufen. An den Durchtrittsstellen 160, 162 und 164 des Fadens 154 durch den Übergangsbereich der Leiterplatte 120 bildet der Faden 154 elektrische Kontakte mit Leitungen, die auf der Leiterplatte 120 angeordnet sind. In der hier betrachteten Ausführungsform sind dies die Leiterbahnen 166, 168 und 170, mit denen der Faden 154 an den Durchtrittsstellen 160, 162 bzw. 164 elektrische Kontakte bildet. Hierdurch werden die Leiterbahnen 166 und 170 mit der Leiterbahn 168 elektrisch verbunden.

Die Leiterbahn 168 ist mit der Anzeigevorrichtung 116 und die Leiterbahnen 166 und 170 sind mit der elektronischen Schaltung 138 verbunden. Die Schaltung 138 beinhaltet bei dieser Ausführungsform einen Mikroprozessor 146, der zur Ausführung von Programminstruktionen 172 und zur Ausführung von Programminstruktionen 174 ausgebildet ist. Die Programminstruktionen 174 dienen zur Prüfung, ob die Naht 136 unversehrt ist, oder ob ein Manipulationsversuch vorliegt.

Sobald elektrische Energie in das Dokument 100 eingekoppelt wird, wird durch Ausführung der Programminstruktionen 174 festgestellt, ob an den Leiterbahnen 166 und 170 ein bestimmtes Signal anliegt, welches von der Anzeigevorrichtung über die Leiterbahn 168 abgegeben wird. Nur wenn dies der Fall ist, sind die an den Durchtrittsstellen 160, 162 und 164 gebildeten elektrischen Kontakte unversehrt, d.h. die Naht 136 ist intakt. Wenn dies der Fall ist, wird nachfolgend die Ausführung der Programminstruktionen 172 gestartet, beispielsweise um Bilddaten aus dem Speicher 144 auszulesen, und um diese auf der Anzeigevorrichtung 116 wiederzugeben.

Alternativ oder zusätzlich zu den Leiterbahnen können auf der Leiterplatte 120 andere elektrische oder elektronische Komponenten angeordnet sein, die durch den Faden 154 elektrisch miteinander verbunden werden.

### Bezugszeichen liste

- 100: Dokument
- 102: Buchdeckel
- 104: Buchdeckel
- 106: Personalisierseitie
- 108: Schicht
- 110: Schicht
- 112: Textfeld
- 114: Textfeld
- 116: Anzeigevorrichtung
- 118: Bild
- 120: Leiterplatte
- 122: Bereich
- 124: Bereich
- 126: Leiter
- 128: Leiter
- 130: Anschlusskontakt
- 132: Anschlusskontakt
- 134: Innenbögen
- 136: Naht
- 138: Schaltung
- 140: Leitungen
- 142: Spule
- 144: Speicher
- 146: Mikroprozessor
- 148: Treiber
- 150: Kavität
- 152: Vorsatz
- 154: Faden
- 156: Bereich
- 158: Bereich
- 160: Durchtrittsstelle
- 162: Durchtrittsstelle
- 164: Durchtrittsstelle
- 166: Leiterbahn
- 168: Leiterbahn
- 170: Leiterbahn
- 172: Programminstruktionen
- 174: Programminstruktionen

## Patentansprüche

1. Buchförmiges Dokument (100) mit einem Buchdeckel (102, 104) und einer Personalisierseite (106),
wobei die Personalisierseite (106) mit dem Buchdeckel (102, 104) durch eine Buchbindung verbunden ist und in der Personalisierseite (106) eine Anzeigevorrichtung (116) angeordnet ist,
und mit einer elektronischen Schaltung (138) zur Ansteuerung der Anzeigevorrichtung (116),
**dadurch gekennzeichnet, dass**
die elektronische Schaltung (138) in den Buchdeckel (102, 104) integriert ist,
und eine flexible Leiterplatte (120) vorgesehen ist, welche sich über oder durch die Buchbindung (136) zwischen der Anzeigevorrichtung (116) und der elektronischen Schaltung (138) erstreckt.

2. Dokument (100) nach Anspruch 1, wobei die elektronische Schaltung (138) und ein Bereich (124) der Leiterplatte (120), welcher die elektronische Schaltung (138) trägt, unter einem Vorsatz (152) des Buchdeckels (102, 104) angeordnet sind.

3. Dokument (100) nach Anspruch 1 oder 2, wobei die Personalisierseite (106) eine Dicke von 150 µm bis 600 µm, insbesondere zwischen 150 µm bis 400 µm aufweist, und/oder wobei die Personalisierseite (106) eine der mehrere Kunststoffschichten (108, 110) aufweist.

4. Dokument (100) nach einem der vorhergehenden Ansprüche, wobei sich die elektronische Schaltung (138) auf einem ersten Bereich (124) der Leiterplatte (120) befindet und wobei die Leiterplatte (120) in einem zweiten Bereich (122) die Anzeigevorrichtung (116) kontaktiert.

5. Dokument (100) nach einem der vorhergehenden Ansprüche, mit einer Naht (136) zur Verbindung der Personalisierseite (106) mit einem oder mehreren Innenbögen (134), wobei die Naht (136) einen Faden (154) aufweist, der durch die Leiterplatte (120) hindurch (160, 162, 164) verläuft.

6. Dokument (100) nach Anspruch 5, wobei der Faden (154) leitfähig ist und einen elektrischen Kontakt zwischen zumindest ersten und zweiten Leiterbahnen (166, 168, 170) der Leiterplatte (120) herstellt.

7. Dokument (100) nach Anspruch 6, wobei die erste Leiterbahn (166, 170) mit der elektrischen Schaltung (138) und die zweite Leiterbahn (168) mit der Anzeigevorrichtung (116) verbunden ist, wobei die elektrische Schaltung (138) eine Abfragelogik (146, 174) beinhaltet, um zu prüfen, ob die zweite Leiterbahn (168) über den Faden (154) mit der ersten Leiterbahn (166, 170) elektrisch verbunden ist.

8. Dokument (100) nach Anspruch 6, wobei die Spannungsversorgung der Schaltung (138) und/oder der Anzeigevorrichtung (116) über einen Abschnitt des Fadens (154) erfolgt.

9. Dokument (100) nach einem der Ansprüche 5 bis 8, wobei durch den Faden (154) eine Brücke (156, 158) über eine oder mehrere weitere Leiterbahnen (140) der Leiterplatte (120) gebildet wird.

10. Dokument (100) nach Anspruch 9, wobei es sich bei den weiteren Leiterbahnen (140) um Zeilen- oder Spaltenleitungen zur Ansteuerung der Anzeigevorrichtung (116) handelt.

11. Verfahren zur Herstellung eines buchförmigen Dokuments (100) mit folgenden Schritten:
- Herstellung einer Personalisierseite (106) mit einer Anzeigevorrichtung (116) und einer flexiblen Leiterplatte (120), welche die Anzeigevorrichtung (116) kontaktiert, wobei die Leiterplatte (120) einen Bereich (124) aufweist, der aus der Personalisierseite (106) herausragt, wobei der aus der Personalisierseite (106) herausragende Bereich (124) eine elektronische Schaltung (138) zur Ansteuerung der Anzeigevorrichtung (116) aufweist,
- Befestigung des aus der Personalisierseite (106) herausragenden Bereichs (124) der Leiterplatte (120) in einem Buchdeckel (102, 104) und schwenkbare Befestigung der Personalisierseite (106) an dem Buchdeckel (102, 104).

12. Verfahren nach Anspruch 11, mit folgendem weiteren Schritt: Verbindung der Personalisierseite (106) mit einem oder mehreren Innenbögen (134) durch eine Naht (136), wobei die Naht (136) durch die Leiterplatte (120) verläuft.

13. Verfahren nach Anspruch 12, wobei ein Faden der Naht (136) leitfähig ist, und wobei durch den Faden (154) zumindest erste und zweite, auf der Leiterplatte (120) angeordnete elektrische oder elektronische Komponenten (166, 168, 170) miteinander kontaktiert werden.

## Claims

1. A book-like document (100) having a book cover (102, 104) and a personalised page (106), wherein the personalised page (106) is connected to the book cover (102, 104) by a bookbinding, and a display device (116) is arranged in the personalised page (106), and having an electronic circuit (138) for actuating the display device (116), **characterised in that** the electronic circuit (138) is integrated in the book cover (102, 104), and a flexible printed circuit board (120) is provided, which extends over or through the bookbinding (136) between the display device (116) and the electronic circuit (138).

2. The document (100) according to Claim 1, wherein the electronic circuit (138) and a region (124) of the printed circuit board (120), which is carried by the electronic circuit (138), are arranged beneath a flyleaf (152) of the book cover (102, 104).

3. The document (100) according to Claim 1 or 2, wherein the personalised page (106) has a thickness from 150 µm to 600 µm, in particular between 150 µm to 400 µm, and/or wherein the personalised page (106) has one or more plastic layers (108, 110).

4. The document (100) according to one of the preceding claims, wherein the electronic circuit (138) is located on a first region (124) of the printed circuit board (120), and wherein the printed circuit board (120) contacts the display device (116) in a second region (122).

5. The document (100) according to one of the preceding claims, having a seam (136) for connecting the personalised page (106) to one or more inner sheets (134), wherein the seam (136) has a thread (154), which runs through (160, 162, 164) the printed circuit board (120).

6. The document (100) according to Claim 5, wherein the thread (154) is conductive and produces electrical contact between at least first and second strip conductors (166, 168, 170) of the printed circuit board (120).

7. The document (100) according to Claim 6, wherein the first strip conductor (166, 170) is connected to the electrical circuit (138) and the second strip conductor (168) is connected to the display device (116), wherein the electrical circuit (138) contains a query logic (146, 174) in order to check whether the second strip conductor (168) is electrically connected to the first strip conductor (166, 170) via the thread (154).

8. The document (100) according to Claim 6, wherein voltage is supplied to the circuit (138) and/or the display device (116) via a portion of the thread (154).

9. The document (100) according to one of Claims 5 to 8, wherein a bridge (156, 158) is formed by the thread (154) via one or more further strip conductors (140) of the printed circuit board (120).

10. The document (100) according to Claim 9, wherein the further strip conductors (140) are row or column lines for actuating the display device (116).

11. A method for producing a book-like document (100), said method having the following steps:
- producing a personalised page (106) having a display device (116) and a flexible printed circuit board (120), which contacts the display device (116), wherein the printed circuit board (120) has a region (124), which protrudes from the personalised page (106), wherein the region (124) protruding from the personalised page (106) has an electronic circuit (138) for actuating the display device (116),
- fastening the region (124) of the printed circuit board (120) protruding from the personalised page (106) in a book cover (102, 104) and pivotably fastening the personalised page (106) to the book cover (102, 104).

12. The method according to Claim 11 having the following further step: connecting the personalised page (106) to one or more inner sheets (134) by a seam (136), wherein the seam (136) runs through the printed circuit board (120).

13. The method according to Claim 12, wherein a thread of the seam (136) is conductive, and wherein at least first and second electrical or electronic components (166, 168, 170) arranged on the printed circuit board (120) are contacted with one another by the thread (154).

## Revendications

1. Document (100) en forme de livre avec une couverture de livre (102, 104) et une page de personnalisation (106), dans lequel la page de personnalisation (106) est reliée avec la couverture de livre (102, 104) par une reliure de livre et un dispositif d'affichage (116) est disposé dans la page de personnalisation (106),
et avec un circuit électronique (138) pour la commande du dispositif d'affichage (116),
**caractérisé en ce que**
le circuit électronique (138) est intégré dans la couverture de livre (102, 104),
et un circuit imprimé (120) souple est prévu, lequel s'étend par-dessus et à travers la reliure de livre (138) entre le dispositif d'affichage (116) et le circuit électronique (138).

2. Document (100) selon la revendication 1, dans lequel le circuit électronique (138) et une zone (124) du circuit imprimé (120), laquelle contient le circuit électronique (138), sont agencés sous un prolongement (152) de la couverture de livre (102, 104).

3. Document (100) selon les revendications 1 ou 2, dans lequel la page de personnalisation (106) présente une épaisseur de 150 µm à 600 µm, notamment entre 150 µm et 400 µm, et/ou la page de personnalisation (106) présente une ou plusieurs couches en matière synthétique (108, 120).

4. Document (100) selon l'une des revendications précédentes, dans lequel le circuit électronique (138) se trouve sur une première zone (124) du circuit imprimé (120) et dans lequel le circuit imprimé (120) est en contact avec le dispositif d'affichage (116) dans une deuxième zone (122).

5. Document (100) selon l'une des revendications précédentes, avec une couture (136) pour la liaison de la page de personnalisation (106) avec un ou plusieurs feuillets internes (134), dans lequel la couture (136) présente un fil (154) qui s'étend à travers (160, 162, 164) le circuit imprimé (120).

6. Document (100) selon la revendication 5, dans lequel le fil (154) est conducteur et établit un contact électrique entre au moins des premières et des secondes bandes conductrices (166, 168, 170) du circuit imprimé (120).

7. Document (100) selon la revendication 6, dans lequel la première bande conductrice (166, 170) est reliée avec le circuit électrique (138) et la deuxième bande conductrice (168) est reliée avec le dispositif d'affichage (116), dans lequel la circuit électrique (138) contient une logique de question - réponse (146, 174) afin de contrôler si la deuxième bande conductrice (168) est reliée électriquement avec la première bande conductrice (166, 170) par l'intermédiaire du fil (154).

8. Document (100) selon la revendication 6, dans lequel l'alimentation de la tension du circuit (138) et/ou du dispositif d'affichage (116) a lieu par l'intermédiaire d'une portion du fil (154).

9. Document (100) selon l'une des revendications 5 à 8, dans lequel un pontage (156, 158) est formé par dessus une ou plusieurs bandes conductrices (140) du circuit imprimé (120) par le fil (154).

10. Document (100) selon la revendication 9, dans lequel il s'agit de conducteurs de lignes ou de conducteurs de colonnes pour la commande du dispositif d'affichage (116) dans le cas des autres bandes conductrices (140).

11. Procédé de fabrication d'un document (100) sous forme de livre avec les étapes suivantes :
- fabrication d'une page de personnalisation (106) avec un dispositif d'affichage (116) et un circuit imprimé (120) souple, lequel est en contact avec le dispositif d'affichage (116), dans lequel le circuit imprimé (120) présente une zone (124) qui dépasse de la page de personnalisation (106), dans lequel la zone (124) dépassant de la page de personnalisation (106) présente une circuit électronique (138) pour la commande du dispositif d'affichage (116),
- fixation de la zone (124) du circuit imprimé (120) dépassant de la page de personnalisation (106) dans une couverture de livre (102, 104) et fixation pivotante de la page de personnalisation (106) sur la couverture de livre (102, 104).

12. Procédé selon la revendication 11, avec l'autre étape suivante : liaison de la page de personnalisation (106) avec un ou plusieurs feuillets internes (134) par une couture (136), dans lequel la couture (136) s'étend à travers le circuit imprimé (120).

13. Procédé selon la revendication 12, dans lequel un fil de la couture (136) est conducteur, et dans lequel au moins des premiers et des seconds composants électriques ou électroniques (166, 168, 170) disposés sur le circuit imprimé (120) sont mis en contact les uns avec les autres par le fil (154).
